Europäisches Patentamt

European Patent Office

Office européen des brevets

(19)

(11) Numéro de publication : **0 117 810**
**B1**

# (12) FASCICULE DE BREVET EUROPÉEN

(45) Date de publication du fascicule du brevet :
06.05.87

(51) Int. Cl.⁴ : **G 01 R   1/067**, H 01 L 21/66

(21) Numéro de dépôt : **84400338.4**

(22) Date de dépôt : **17.02.84**

(54) **Dispositif de contrôle des charges électriques mobiles dans un circuit intégré en technologie MOS.**

(30) Priorité : 24.02.83 FR 8303046

(43) Date de publication de la demande :
05.09.84 Bulletin 84/36

(45) Mention de la délivrance du brevet :
06.05.87 Bulletin 87/19

(84) Etats contractants désignés :
CH DE GB IT LI NL

(56) Documents cités :
US-A- 4 340 860
IBM TECHNICAL DISCLOSURE BULLETIN, vol. 16,
no. 2, juillet 1973, pages 692-693, Armonk, US, H.W.
CURTIS et al.: "Probe analysis technique for semi-
conductor testing"
IBM TECHNICAL DISCLOSURE BULLETIN, vol. 14,
no. 6, novembre 1971, pages 1924-1925, Armonk, US,
R. HAMMER: "High-temperature multicontact test
probe"

(73) Titulaire : **COMMISSARIAT A L'ENERGIE ATOMIQUE**
**Etablissement de Caractère Scientifique Technique**
**et Industriel**
**B.P. 510**
**F-75752 Paris Cedex 15 (FR)**

(72) Inventeur : **Hartmann, Joel**
**13, rue de la Balmette**
**F-38640 Claix (FR)**
Inventeur : **Jeuch, Pierre**
**13, rue du Parc**
**F-38170 Seyssins (FR)**

(74) Mandataire : **Mongrédien, André et al**
**c/o BREVATOME 25, rue de Ponthieu**
**F-75008 Paris (FR)**

EP 0 117 810 B1

Jouve, 18, rue St-Denis, 75001 Paris, France

## Description

La présente invention a pour objet un dispositif de contrôle des charges électriques mobiles dans un circuit intégré en technologie MOS.

Les éléments des circuits intégrés tels que les grilles de transistors réalisés en technologie MOS sont constitués par la superposition de trois couches : une couche M métallique formant l'électrode de la grille, une couche O d'oxyde et une couche S constituant la plaque de silicium dopé. La couche O d'oxyde contient des impuretés ionisées mobiles. Ces impuretés, piégées dans l'oxyde, peuvent migrer et se comporter comme des charges électriques mobiles. Selon la différence de potentiel appliqué entre l'électrode métallique et la couche de semiconducteur, elles se déplacent vers la frontière métal-oxyde ou vers la frontière oxyde-semiconducteur.

La mise en évidence de ces charges électriques mobiles se fait, de façon connue, par un procédé en trois étapes. Dans une première étape, on relève, pour chacun des points du circuit intégré que l'on désire tester, une caractéristique capacité-tension électrique $C = f_1 (V)$ où V est la différence de potentiel appliquée entre la surface du circuit intégré et la couche S de semiconducteur et C la capacité de la couche O d'oxyde et du semiconducteur au droit du point testé. On applique ensuite à ce point du circuit intégré une contrainte de température-tension électrique. La contrainte de température a pour résultat d'activer la diffusion des impuretés ionisées mobiles de la couche d'oxyde, et la contrainte de tension électrique a pour résultat d'orienter le déplacement des impuretés ionisées mobiles ainsi activées. La contrainte de température est de l'ordre de 200 °C et la contrainte de tension électrique, proportionnelle à l'épaisseur de la couche d'oxyde, est de l'ordre de quelques volts pour une épaisseur d'oxyde de 50 nm. Dans une troisième étape, après le retour à température ambiante, on relève une nouvelle caractéristique capacité-tension électrique $C = f_2 (V)$ du point du circuit intégré. Cette deuxième caractéristique est différente de la première. On connaît par ailleurs la caractéristique capacité-tension électrique théorique $C = f_1 (V)$. La valeur de la capacité $C_{bp}$ correspondant à $V = 0$ sur cette caractéristique est appelée « capacité de bande plate ».

Pour évaluer le nombre de charges électriques mobiles, on relève sur chacune des caractéristiques expérimentales les tensions de bande plate $V_1$ et $V_2$ qui sont données respectivement par les égalités $C_{bp} = f_1 (V_1)$ et $C_{bp} = f_2 (V_2)$. La comparaison entre $V_1$ et $V_2$ fournit une indication sur les charges électriques mobiles présentes dans la couche d'oxyde au droit du point testé.

Pour mettre en œuvre ce procédé de contrôle connu, l'homme de l'art utilise un dispositif comprenant principalement un support de plaque muni de moyens de chauffage sur lequel est déposée une plaque de semiconducteur contenant les circuits intégrés à tester et des moyens de contact électrique constitués de pointes électriques pour exciter électriquement les points des circuits intégrés à tester. Les dispositifs connus comprennent quelques moyens de contact. On peut ainsi relever le nombre de charges mobiles dans l'oxyde en quelques points d'une plaque de circuits intégrés. De manière générale, on effectue séquentiellement pour chaque point à tester la première étape de relevé d'une caractéristique capacité-tension électrique ; on effectue ensuite la deuxième étape de mise sous contrainte température-tension électrique simultanément pour ces mêmes points ; et on réalise enfin la troisième étape de relevé d'une nouvelle caractéristique capacité-tension électrique séquentiellement pour chacun de ces points.

Le désavantage principal de ce dispositif est qu'il ne permet de tester en pratique que quelques points de la plaque de circuits intégrés. En effet, l'étape de mise sous contrainte température-tension électrique est longue ; sa durée est de l'ordre de la dizaine de minutes. Si l'on désire tester plus de points de la plaque de circuits intégrés que l'on a de moyens de contact électrique, il faut donc opérer en plusieurs fois, en mettant sous contrainte température-tension électrique à chaque fois autant de points à tester que l'on dispose de moyens de contact électrique. Il est alors évident que plus l'on désire tester de points, plus le contrôle est coûteux en temps. Dans la pratique, l'homme de l'art limite donc le nombre de points testés au nombre de moyens de contact électrique disponibles, c'est-à-dire à quelques unités.

L'objectif de l'invention est de procurer, de manière simultanée, un moyen de mise sous contrainte température-tension électrique d'un nombre quelconque de points à tester de la plaque de circuits intégrés. Pour cela, l'invention remplace le moyen discret de mise sous contrainte température-tension électrique par un moyen continu mettant sous contrainte toute la surface de la plaque de circuits intégrés.

Ainsi, la durée du contrôle, qui est très largement dépendante de la durée de la mise sous contrainte température-tension électrique devient presque indépendante du nombre de points testés. On peut alors envisager de réaliser une cartographie des densités de charges électriques mobiles dans l'oxyde d'une plaque de circuits intégrés, c'est-à-dire de dessiner un ensemble de courbes isotension de bande plate de la plaque de circuits intégrés en testant un grand nombre de points, de l'ordre d'une centaine ou davantage. Il peut être avantageux dans ce cas d'automatiser le déplacement des moyens de contact électrique d'un point de la plaque de circuits intégrés à un autre et le relevé des tensions de bande plate en ces points. Cette opération pourra donc être faite en une durée beaucoup plus courte qu'avec les dispositifs de l'art antérieur.

De manière plus précise, l'invention a pour objet un dispositif de contrôle des charges électriques mobiles dans un circuit intégré en technologie MOS comprenant un support de plaque muni d'un moyen de chauffage, des moyens pour fixer une plaque de circuits intégrés réalisée en silicium sur ledit support de plaque, au moins un moyen de contact électrique pour appliquer une tension électrique aux points des circuits intégrés à tester, un moyen de polarisation appliquant une différence de potentiel entre les deux faces de la plaque de silicium par l'intermédiaire de deux électrodes, chacune en contact avec l'une des faces de ladite plaque de silicium, caractérisé en ce que la première électrode est constituée d'une membrane conductrice recouvrant la plaque de silicium, cette première électrode étant maintenue en contact avec ladite plaque de silicium par une différence de pression entre ses deux faces, la deuxième électrode étant constituée par le support de plaque électriquement conducteur.

Selon un mode de réalisation privilégié, la membrane est fixée sur un boîtier en forme de U renversé, fermant ainsi la cavité de ce boîtier. Le dispositif comprend en outre un moyen pour créer dans cette cavité une surpression par rapport à la pression externe au boîtier.

Selon un autre mode de réalisation privilégié, le dispositif comprend un joint étanche encerclant la plaque de silicium, posé sur le support de plaque et supportant un boîtier en forme de U renversé sur lequel est fixée la membrane et il comprend un moyen d'aspiration créant une dépression dans le volume encerclé par le joint étanche par rapport à la pression dans la cavité du boîtier.

Selon une caractéristique secondaire, la membrane est une feuille métallique électriquement conductrice.

Selon une autre caractéristique secondaire, la membrane est une feuille électriquement isolante recouverte d'un métal électriquement conducteur.

D'autres caractéristiques et avantages de l'invention ressortiront mieux de la description qui va suivre, donnée à titre illustratif et non limitatif, en référence aux figures annexées dans lesquelles :

la figure 1 représente la grille d'un transistor d'un circuit intégré MOS et un moyen de contact,

la figure 2 représente un mode de réalisation du dispositif selon l'invention,

la figure 3 représente un autre mode de réalisation du dispositif selon l'invention.

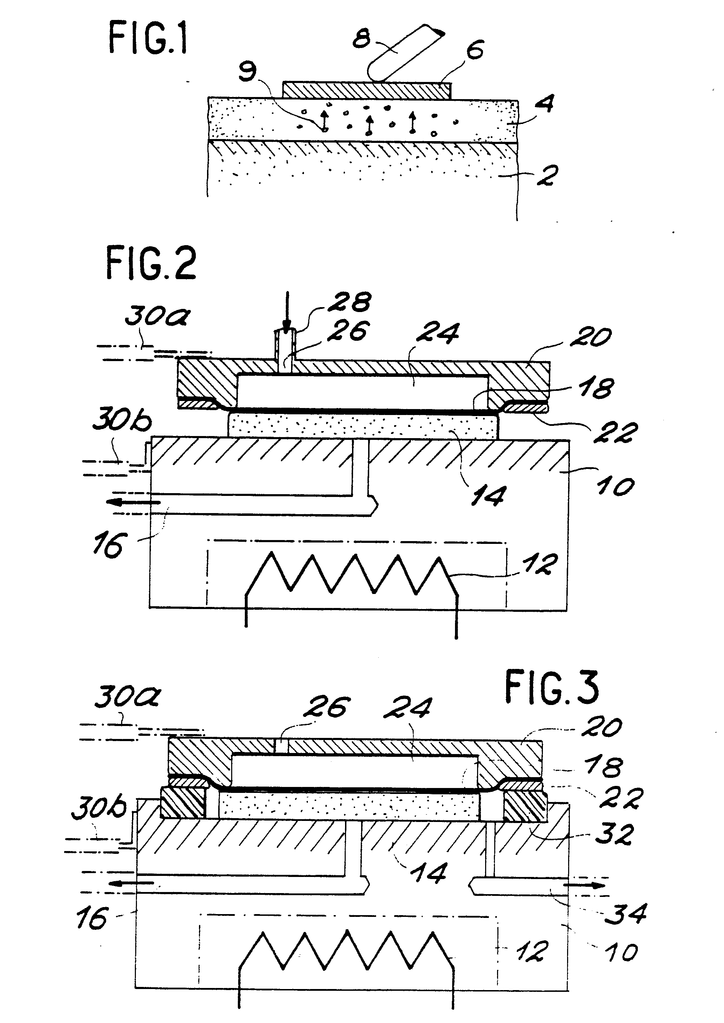

Sur la figure 1, on a représenté la grille d'un transistor d'un élément intégré MOS. Elle comprend une couche 2 constituée d'un semiconducteur dopé, d'une couche d'oxyde 4 dans laquelle des impuretés ionisées sont mobiles, et une couche de métal 6. Un moyen de contact électrique 8 constitué par exemple d'une pointe électrique permet de porter la couche de métal 6 à un potentiel électrique. En portant la couche 2 de semiconducteur à un autre potentiel, on peut alors effectuer le tracé des caractéristiques capacité-tension électrique et l'opération de mise sous contrainte électrique de la zone du circuit intégré située au droit de la couche de métal 6.

La mise sous contrainte de température a pour effet d'activer les impuretés ionisées 9. Le mouvement de ces impuretés ionisées 9 est orienté par la contrainte de tension électrique. Le sens du déplacement des impuretés ionisées 9, représenté sur la figure par des flèches, est arbitraire. Il dépend du sens du champ électrique régnant dans la couche d'oxyde 4, c'est-à-dire du signe de la contrainte de tension électrique appliquée, et il dépend du signe des charges électriques mobiles.

Sur la figure 2, on a représenté un mode de réalisation du dispositif selon l'invention. Ce dispositif comprend un support de plaque 10 muni de moyens de chauffage 12 supportant une plaque de silicium 14 sur laquelle ont été insérés les circuits intégrés à tester. La fixation de la plaque de silicium 14 sur le support de plaque 10 est réalisée par aspiration au moyen d'une pompe (non représentée) reliée à un conduit 16 percé dans le support de plaque 10. L'ensemble du dispositif est sous pression atmosphérique.

La mise sous contrainte de température de la plaque de silicium 14 se fait par l'intermédiaire du support de plaque 10 thermiquement conducteur muni d'un moyen de chauffage 12. La mise sous contrainte de tension électrique se fait au moyen de deux conducteurs électriques 30a et 30b, le premier appliquant par l'intermédiaire du boîtier 20 et de la membrane conductrice 18 un potentiel sur la face supérieure de la plaque de silicium 14, le second appliquant un potentiel par l'intermédiaire du support de plaque 10 électriquement conducteur sur la face arrière de la plaque de silicium 14. La face arrière de la plaque de silicium 14 est éventuellement traitée pour favoriser une meilleure conductivité électrique. Pour que la membrane conductrice 18 transmette correctement le potentiel qui lui est appliqué à la face supérieure de la plaque de silicium 14, il faut qu'elle soit appuyée sur cette plaque de silicium 14. Ceci se fait dans le cas de cette figure 2, en créant une surpression entre la face de la membrane conductrice 18 qui n'est pas en contact avec la plaque de silicium 14 et la face de la membrane conductrice 18 qui est en contact avec la plaque de silicium 14. Pour ce faire, la membrane conductrice 18 est placée sur un boîtier 20 formant un U inversé. Dans la cavité 24 de ce boîtier 20, on crée une surpression en apportant de l'air comprimé par un canal 28 traversant un orifice 26 du boîtier 20. Une surpression de quelques dixièmes de bar est suffisante si le dispositif est sous pression atmosphérique pour réaliser la force d'appui de la membrane conductrice 18 sur la plaque de silicium 14.

En pratique, la partie 22 du boîtier 20 qui maintient la membrane conductrice 18 est un peu en retrait du plan de la membrane conductrice 18 pour éviter un contact avec le support de plaque 10 chauffant.

Sur la figure 3, on a représenté un autre mode de réalisation du dispositif selon l'invention. Ce dispositif comprend, comme dans la figure précédente, un support de plaque 10 muni d'un moyen de chauffage 12 sur lequel est déposée la plaque de silicium 14 contenant les circuits intégrés à tester, cette plaque étant fixée sur le support de plaque 10 par aspiration au moyen d'une pompe reliée au conduit 16. La membrane conductrice 18 est fixée, comme dans la figure précédente, sur un boîtier 20 en forme de U inversé muni d'un orifice 26. La cavité 24 est donc à la même pression que l'ensemble du dispositif. Pour appliquer la membrane conductrice 18 sur la plaque de silicium 14, on va donc créer une dépression du côté de la face de la membrane conductrice 18 en contact avec la plaque de silicium 14 par rapport à l'autre face de la membrane conductrice 18. Pour créer cette dépression, on utilise un joint d'étanchéité 32 qui encercle la plaque de silicium 14. Ce joint d'étanchéité 32 peut être par exemple de forme torique. Il repose sur le support de plaque 10 et soutient la partie 22 du boîtier 20. Un conduit 34, percé dans le support de plaque 10, est relié d'une part à l'espace encerclé par le joint d'étanchéité 32 et d'autre part à une pompe à vide (non représentée) dont la mise en œuvre permet de réaliser la dépression voulue. Une dépression de quelques dixièmes de bar est suffisante si la cavité 24 du boîtier 20 est à la pression atmosphérique. La pression dans le conduit 34 doit cependant être supérieure à celle régnant dans le conduit 16 pour que la fixation de la plaque de silicium 14 soit assurée.

Plusieurs types de matériau sont utilisables pour réaliser la membrane conductrice 18. Elle peut être constituée par une feuille métallique mince telle que par exemple de l'acier inoxydable, ou bien elle peut être constituée d'une feuille isolante, par exemple de type Kapton ou Milar, recouverte d'une couche conductrice, par exemple de l'aluminium ou du cuivre. Dans le second cas, et si seule une des faces de la membrane conductrice 18 est recouverte d'une couche conductrice, cette face est reliée électriquement au boîtier 20 pour que le potentiel apporté par le conducteur 30a sur le boîtier 20 lui soit transmis.

**Revendications**

1. Dispositif de contrôle des charges électriques mobiles dans un circuit intégré en technologie MOS comprenant un support de plaque (10) muni d'un moyen de chauffage (12), des moyens pour fixer une plaque de circuits intégrés réalisée en silicium sur le support de plaque (10), au moins un moyen de contact électrique (8) pour appliquer une tension électrique aux points des circuits intégrés à tester, un moyen de polarisation (30a et 30b) appliquant une différence de potentiel entre les deux faces de la plaque de silicium (14) portant les circuits intégrés par l'intermédiaire de deux électrodes, chacune en contact avec l'une des faces de la plaque de silicium (14), caractérisé en ce que la première électrode est constituée d'une membrane conductrice (18) recouvrant la plaque de silicium (14), cette première électrode étant maintenue en contact avec la plaque de silicium (14) par une différence de pression entre ses deux faces, la deuxième électrode étant constituée par le support de plaque (10) électriquement conducteur.

2. Dispositif selon la revendication 1, caractérisé en ce que la membrane conductrice (18) est fixée sur un boîtier (20) en forme de U renversé, fermant ainsi la cavité (24) de ce boîtier (20) et en ce qu'il comprend un moyen pour créer dans cette cavité une surpression par rapport à la pression externe du boîtier (20).

3. Dispositif selon la revendication 1, dans lequel la membrane conductrice (18) est fixée sur un boîtier (20) en forme de U renversé, caractérisé en ce qu'il comprend un joint étanche (32) encerclant la plaque de silicium (14), posé sur le support de plaque (10) et supportant le boîtier (20), et en ce qu'il comprend un moyen d'aspiration créant une dépression dans le volume encerclé par le joint étanche (32) par rapport à la pression dans la cavité (24) du boîtier (20).

4. Dispositif selon l'une quelconque des revendications 2 et 3, caractérisé en ce que la membrane conductrice (18) est une feuille métallique électriquement conductrice.

5. Dispositif selon l'une quelconque des revendications 2 et 3, caractérisé en ce que la membrane conductrice (18) est une feuille électriquement isolante recouverte d'un métal électriquement conducteur.

**Claims**

1. Device for checking moving electrical charges in an MOS technology integrated circuit comprising a chip support (10) provided with a means of heating (12), means of fixing an integrated circuits chip made from silicon on the chip support (10), at least one means of electrical contact (8) for applying an electrical voltage tb the points of the integrated circuits to be tested, a means of bias (30a and 30b) applying a potential difference between the two faces of the silicon chip (14) carrying the integrated circuits by means of two electrodes, each in contact with one of the faces of the silicon chip (14), characterized in that the first electrode is formed from a conductive membrane (18) covering the silicon chip (14), this first electrode being held in contact with the silicon chip (14) by a difference in pressure between its two faces, the second electrode being formed by the chip support (10) which is electrically conductive.

2. Device according to Claim 1, characterized in that the conductive membrane (18) is fixed to a casing (20) which is of inverted « U » shape, thus closing the cavity (24) of this casing (20), and in that it includes a means of creating an excess pressure inside this cavity with respect to the pressure outside the casing (20).

3. Device according to Claim 1, in which the conductive membrane (18) is fixed to a casing (20) which is of inverted « U » shape, characterized in that it includes a leak-proof gasket (32) surrounding the silicon chip (14), placed on the chip support (10) and supporting the casing (20), and in that it includes a means of aspiration creating a reduced pressure inside the volume enclosed by the leak-proof gasket (32) with respect to the pressure inside the cavity (24) of the casing (20).

4. Device according to either of Claims 2 and 3, characterized in that the conductive membrane (18) is an electrically conductive metallic sheet.

5. Device according to either of Claims 2 and 3, characterized in that the conductive membrane (18) is an electrically insulating sheet covered with an electrically conductive metal.

**Patentansprüche**

1. Anordnung zum überwachen von beweglichen elektrischen Ladungen in einem in MOS-Technologie ausgeführten integrierten Schaltkreis, enthaltend eine Trägerplatte (10), die mit einer Heizvorrichtung (12) versehen ist, mit Einrichtungen zum Befestigen einer integrierten Schaltungsplatte, die in Silizium ausgeführt ist, auf der Trägerplatte (10), wenigstens einer elektrischen Kontakteinrichtung (8) zum Anlegen einer elektrischen Spannung an die Punkte der zu untersuchenden integrierten Schaltungen, einer Polarisierungseinrichtung (30a und 30b), die eine Potentialdifferenz an die zwei Seiten der Siliziumplatte (14) anlegt, die die integrierten Schaltungen trägt, mit Hilfe von zwei Elektroden, von denen jede in Berührung mit einer der Seiten der Siliziumplatte (14) ist, dadurch gekennzeichnet, daß die erste Elektrode von einer leitfähigen Membran (18) gebildet ist, die die Siliziumplatte (14) bedeckt, wobei diese erste Elektrode durch eine Druckdifferenz zwischen ihren zwei Seiten in Berührung mit der Siliziumplatte (14) gehalten ist, wobei die zweite Elektrode vond der Tragplatte (10) gebildet ist, die elektrisch leitfähig ist.

2. Anordnung nach Anspruch 1, dadurch gekennzeichnet, daß die Leitfähige Membran (18) an einem Behälter (20) umgekehrt U-förmiger Gestalt befestigt ist, auf diese Weise den Hohlraum (24) dieses Behälters (20) verschließend, und daß sie eine Einrichtung zum Erzeugen eines Überdrucks in diesem Hohlraum in bezug auf den Außendruck des Behälters (20) aufweist.

3. Anordnung nach Anspruch 1, bei der die Leitfähige Membran (18) über einem umgekehrt U-förmigen Behälter (20) befestigt ist, dadurch gekennzeichnet, daß sie eine Dichtung (32) aufweist, die die Siliziumplatte (14) umgibt, auf der Tragplatte (10) aufliegt und den Behälter (20) trägt, und daß sie eine Saugeinrichtung enthält, die in dem von der Dichtung (32) umgebenen Raum einen Unterdruck in bezug auf den in dem Hohlraum (24) des Behälters (20) herrschenden Druck erzeugt.

4. Anordnung nach einem der Ansprüche 2 und 3, dadurch gekennzeichnet, daß die Leitfähige Membran (18) eine elektrisch Leitfähige Metallfolie ist.

5. Anordnung nach einem der Ansprüche 2 und 3, dadurch gekennzeichnet, daß die Leitfähige Membran (18) eine elektrisch isolierende Folie ist, die von einem elektrisch Leitfähigen Metall bedeckt ist.

0 1 1 7 8 1 0

FIG.1

FIG.2

FIG.3